# EUROPEAN PATENT APPLICATION

(11) **EP 4 796 940 A1**
(43) Date of publication of application: **26.08.2026**
(21) Application number: 25828490.0
(22) Date of filing: 23.09.2025
(51) Int. Cl.: G01R 31/371

(54) **BATTERY TRIGGER DEVICE**

(30) Priority: 31.12.2024 CN 202423319466 U
(71) Applicant: Contemporary Amperex Technology Co., Limited, Ningde, Fujian 352100 (CN)
(72) Inventor: KONG, Chunfang, Ningde, Fujian 352100 (CN)
(74) Representative: Ziebig Hengelhaupt Intellectual Property Attorneys Patentanwaltskanzlei PartGmbB
(86) International application number: PCT/CN2025/123339
(87) International publication number: WO 2026/144306

(57) **Abstract**

A battery trigger device belonging to the field of battery technology is provided. The battery trigger device includes: an input device and a message generation device; the message generation device includes a wireless communication module and a control module; the wireless communication module is wirelessly connected to the input device; the wireless communication module is configured to acquire target data sent by the input device; the control module is connected to the wireless communication module; the control module is provided with a wired communication interface for connecting to a management device of a target battery apparatus; the control module is configured to generate a target signal based on the target data and output the target signal to the management device; and the target signal is used to trigger the target battery apparatus to output electrical energy.

## Description

### CROSS-REFERENCE TO RELATED APPLICATIONS

This application is based on and claims priority to Chinese Patent Application No. 202423319466.6, filed on December 31, 2024, which is incorporated herein by reference in its entirety.

### TECHNICAL FIELD

This application relates to the field of battery technology, and in particular, to a battery trigger device, a teaching aid, and a test system.

### BACKGROUND ART

In scenarios such as testing or training related to battery apparatuses, it is necessary to trigger the battery to output electrical energy. Currently, this is generally achieved by sending instructions to a battery management system (Battery Management System, BMS) or battery management unit (Battery Management Unit, BMU) associated with the battery. The BMS or BMU controls the battery based on these instructions to trigger the output of electrical energy. In testing or training scenarios for batteries, users typically operate physical buttons on a communication signal generator to generate corresponding simulated instructions based on data stored in the memory of the communication signal generator. This approach has drawbacks, such as inconvenience in use.

### SUMMARY OF THE INVENTION

This application provides a battery trigger device, a teaching aid, and a test system to improve ease of use.

According to a first aspect, embodiments of this application provide a battery trigger device, including: an input device and a message generation device; wherein the message generation device includes a wireless communication module and a control module;
the wireless communication module is wirelessly connected to the input device; and the wireless communication module is configured to acquire target data sent by the input device; and
the control module is connected to the wireless communication module; the control module is provided with a wired communication interface for connecting to a management device of a target battery apparatus; the control module is configured to generate a target signal based on the target data and output the target signal to the management device; and the target signal is used to trigger the target battery apparatus to output electrical energy.

In the above technical solution, through the wireless connection between the input device and the wireless communication module of the message generation device, the target data input by the input device is transmitted to the control module of the message generation device via the wireless communication module. The control module generates a target signal based on the target data and outputs the target signal to the management device of the target battery apparatus to trigger the target battery apparatus to output electrical energy. This eliminates the need for expensive and cumbersome power distribution harnesses, resulting in a simpler and more aesthetically pleasing layout. There is no need for external or reserved interfaces, making the overall device appearance more attractive and facilitating easier and faster fault diagnosis. Without modifying or disassembling the wiring harness, a simple and compact message generation device, paired with a dedicated input device, can wirelessly modify, store, or delete the sent data of the message generation device to achieve specific functions while ensuring safety. Data modification is simpler, more convenient, and flexible, enhancing the overall usability of the device. Additionally, by using the message generation device, connections to components such as the drive system, vehicle controller, and DC/DC converter can be reduced, lowering the failure rate during device power-up or use and reducing safety risks during high-voltage power-up of the battery apparatus.

In some embodiments, the control module includes a controller and a transceiver;
the controller is connected to the wireless communication module; and the controller is configured to generate a target message based on the target data; and
the transceiver is connected to the controller; and the transceiver is configured to convert the target message into the target signal.

In some embodiments, the transceiver is a CAN transceiver.

In some embodiments, the battery trigger device further includes a power supply device; where the power supply device is connected to the message generation device to supply power to the message generation device.

In some embodiments, the power supply device includes a DC source, a first buck module, and a second buck module;
an input end of the first buck module is connected to the DC source; an output end of the first buck module is connected to both an input end of the second buck module and a power supply end of the transceiver; and an output voltage of the first buck module is less than an input voltage of the first buck module; and
an output end of the second buck module is connected to a power supply end of the controller; and an output voltage of the second buck module is less than an input voltage of the second buck module.

In some embodiments, the output end of the second buck module is connected to a power supply end of the wireless communication module.

In some embodiments, the message generation device further includes a first buck unit and a second buck unit;
an output end of the first buck unit is connected to both an input end of the second buck unit and the power supply end of the transceiver; and an output voltage of the first buck unit is less than an input voltage of the first buck unit; and
an output end of the second buck unit is connected to the power supply end of the controller; and an output voltage of the second buck unit is less than an input voltage of the second buck unit.

In some embodiments, the message generation device further includes a switching power supply; and an input end of the first buck unit is connected to the switching power supply.

In some embodiments, the output end of the second buck unit is connected to the power supply end of the wireless communication module.

In some embodiments, the input device includes at least one of a terminal and a keyboard.

According to a second aspect, embodiments of this application provide a teaching aid, including: a teaching device, a battery apparatus, a management device of a target battery apparatus, and the battery trigger device as described in the first aspect; and
the teaching device is connected to the battery trigger device; the battery trigger device is connected to the management device; and the management device is connected to a control end of the battery apparatus.

In the above technical solution, by adopting the battery trigger device provided in any of the foregoing embodiments, a simple and compact message generation device, paired with a dedicated input device, can wirelessly modify, store, or delete the sent data of the message generation device to achieve specific functions without modifying or disassembling the wiring harness, ensuring safety and improving ease of use.

In some embodiments, the teaching device includes a housing; and the message generation device of the battery trigger device is disposed within the housing.

According to a third aspect, embodiments of this application provide a test system, including: a test device and the battery trigger device as described in the first aspect; wherein the test device is connected to the battery trigger device.

In the above technical solution, by adopting the battery trigger device provided in any of the foregoing embodiments, a simple and compact message generation device, paired with a dedicated input device, can wirelessly modify, store, or delete the sent data of the message generation device to achieve specific functions without modifying or disassembling the wiring harness, ensuring safety and improving ease of use.

In some embodiments, the test device includes a housing; and the message generation device of the battery trigger device is disposed within the housing.

### DESCRIPTION OF DRAWINGS

To more clearly illustrate the technical solutions of the embodiments of this application, the drawings required for use in the embodiments are briefly introduced below. It should be understood that the following drawings only show certain embodiments of this application and should not be regarded as limiting the scope. For those skilled in the art, other related drawings can be obtained based on these drawings without creative effort.
FIG. 1 is a schematic structural diagram of a battery trigger device provided in some embodiments of this application;
FIG. 2 is a schematic structural diagram of a Wi-Fi module provided in some embodiments of this application;
FIG. 3 is a schematic structural diagram of a CPU provided in some embodiments of this application;
FIG. 4 is a schematic structural diagram of a CAN transceiver chip provided in some embodiments of this application;
FIG. 5 is a schematic structural diagram of a first buck module or first buck unit provided in some embodiments of this application;
FIG. 6 is a schematic structural diagram of a second buck module or second buck unit provided in some embodiments of this application;
FIG. 7 is a schematic structural diagram of a switching power supply provided in some embodiments of this application;
FIG. 8 is a schematic structural diagram of a teaching aid provided in some embodiments of this application; and
FIG. 9 is a schematic structural diagram of a test system provided in some embodiments of this application.

### Reference signs:

battery trigger device 100, input device 110, message generation device 120; management device 130; power supply device 140;
wireless communication module 121, control module 122, controller 1221, transceiver 1222;
DC source 141, first buck module 142, second buck module 143;
teaching aid 800, teaching device 810, battery apparatus 820, test system 900, and test device 910.

### DETAILED DESCRIPTION

To make the objectives, technical solutions, and advantages of the embodiments of this application clearer, the technical solutions in the embodiments of this application are described clearly below with reference to the drawings in the embodiments of this application. Obviously, the described embodiments are some, but not all, embodiments of this application. Based on the embodiments in this application, all other embodiments obtained by those skilled in the art without creative effort fall within the protection scope of this application.

Unless otherwise defined, all technical and scientific terms used in this application have the same meanings as commonly understood by those skilled in the technical field of this application; the terms used in the specification of this application are for the purpose of describing specific embodiments only and are not intended to limit this application; the terms "including" and "having" and any variations thereof in the specification, claims, and the above description of drawings of this application are intended to cover non-exclusive inclusion. The terms "first," "second," and the like in the specification, claims, or the above description of drawings of this application are used to distinguish different objects, not to describe a specific order or primary-secondary relationship.

Reference to "embodiment" in this application means that a specific feature, structure, or characteristic described in connection with the embodiment can be included in at least one embodiment of this application. The appearance of this phrase in various places in the specification does not necessarily refer to the same embodiment, nor is it a separate or alternative embodiment mutually exclusive with other embodiments. Those skilled in the art explicitly and implicitly understand that the embodiments described in this application can be combined with other embodiments.

In the description of this application, it should be noted that, unless otherwise expressly specified and limited, the terms "installed," "connected," "connection," and "attached" should be understood in a broad sense, for example, it can be a fixed connection, a detachable connection, or an integral connection; it can be a direct connection, an indirect connection through an intermediary, or an internal connection between two components. For those skilled in the art, the specific meanings of the above terms in this application can be understood according to specific circumstances.

The term "and/or" in this application is merely an association relationship describing associated objects, indicating that three relationships may exist, for example, A and/or B can indicate: A alone, both A and B, and B alone. In addition, the character "/" in this application generally indicates that the associated objects before and after are in an "or" relationship.

The term "multiple" appearing in this application refers to two or more (including two), similarly, "multiple groups" refers to two or more groups (including two groups), and "multiple pieces" refers to two or more pieces (including two pieces).

In the embodiments of this application, a battery cell can be a secondary battery, which refers to a battery cell that can be recharged to activate the active material for continued use after discharge.

The battery cell can be a lithium-ion battery, sodium-ion battery, sodium-lithium-ion battery, lithium metal battery, sodium metal battery, lithium-sulfur battery, magnesium-ion battery, nickel-hydrogen battery, nickel-cadmium battery, lead-acid battery, and the like, which is not limited in the embodiments of this application.

The battery cell may have a cylindrical, flat, rectangular, or other shape, which is not limited in the embodiments of this application. Battery cells are generally divided into three types according to encapsulation methods: cylindrical battery cells, prismatic battery cells, and pouch battery cells, which is not limited in the embodiments of this application.

A battery cell includes a housing, an electrode assembly, and an electrolyte, with the housing used to accommodate the electrode assembly and the electrolyte. The electrode assembly consists of a positive electrode plate, a negative electrode plate, and a separator. The battery cell primarily operates by the movement of metal ions between the positive and negative electrode plates. The positive electrode plate includes a positive current collector and a positive active material layer, the positive current collector includes a positive current collector body and a positive tab, the positive active material layer is coated on the surface of the positive current collector body, the positive tab is not coated with the positive active material layer and protrudes from the positive current collector body. Taking a lithium-ion battery as an example, the material of the positive current collector can be aluminum, and the positive active material can be lithium cobalt oxide, lithium iron phosphate, ternary lithium, or lithium manganate, and the like. The negative electrode plate includes a negative current collector and a negative active material layer, the negative current collector includes a negative current collector body and a negative tab, the negative active material layer is coated on the surface of the negative current collector body, the negative tab is not coated with the negative active material layer and protrudes from the negative current collector body. The material of the negative current collector can be copper, and the negative active material can be carbon or silicon, and the like. To ensure that large currents can pass without fusing, the number of positive tabs is multiple and stacked together, and the number of negative tabs is multiple and stacked together.

The material of the separator can be PP (polypropylene, polypropylene) or PE (polyethylene, polyethylene), and the like. In addition, the electrode assembly can be a wound structure or a laminated structure, which is not limited in the embodiments of this application.

The technical solutions described in the embodiments of this application are applicable to various electrical devices using battery cells, such as mobile phones, portable devices, laptops, electric scooters, electric toys, power tools, vehicles, ships, and spacecraft, for example, spacecraft including airplanes, rockets, space shuttles, and spaceships, and the like. Battery cells are used to store or provide electrical energy.

The battery apparatus (Battery Apparatus) mentioned in the embodiments of this application may include one or more battery cell assemblies for providing voltage and capacity. A battery cell assembly (Battery Cell Assembly) may include multiple battery cells, with the multiple battery cells connected in series, parallel, or a combination thereof through busbar components.

In some embodiments, a battery cell assembly (Battery Cell Assembly) is typically formed by arranging multiple battery cells.

As an example, the battery cell assembly can be a battery module (Battery Module), where the battery module is formed by arranging and fixing multiple battery cells into an independent module. As an example, the battery module can be formed by bundling multiple battery cells with straps.

In some embodiments, the battery apparatus can be a battery pack (battery Pack), which includes a casing and one or more battery cell assemblies, with the battery cell assemblies accommodated in the casing.

As an example, the battery cell assembly can be a battery module, and the battery cell assembly can be accommodated in the casing by fixing the battery module in the casing.

As an example, the battery cell assembly can also be accommodated in the casing by directly fixing multiple battery cells in the casing.

As an example, the casing may include a first casing and a second casing. The first casing and the second casing are snap-fitted together to form an enclosed space inside the casing to accommodate the battery cell assembly. The term "enclosed" here refers to covering or closing, which can be sealed or unsealed. The first casing can be a top cover or a bottom plate.

As an example, the casing may include a top cover, a frame, and a bottom plate. The top cover and the bottom plate are respectively connected to the frame, forming an enclosed space inside the casing to accommodate the battery cell assembly.

In some embodiments, the casing can be part of the chassis structure of a vehicle. For example, a part of the casing can be at least a portion of the vehicle's floor, or a part of the casing can be at least a portion of the vehicle's crossbeam and longitudinal beam.

The technical solutions described in the embodiments of this application are applicable to various electrical devices using battery apparatuses, such as mobile phones, portable devices, laptops, electric scooters, electric toys, power tools, vehicles, ships, and spacecraft, for example, spacecraft including airplanes, rockets, space shuttles, and spaceships, and the like. Battery apparatuses are used to store or provide electrical energy.

The inventor found that in scenarios such as testing or teaching and training related to battery apparatuses, devices with physical buttons are typically used to generate simulated instructions to trigger the battery to output electrical energy. For example, a CAN communication signal generator including a CAN communication module, a microcontroller module, an SD card storage module, a button module, a display module, and a buck module is used. The SD card storage module, display module, and buck module are all electrically connected to the microcontroller module, the buck module is electrically connected to the input power supply through a connection line, the microcontroller module is signal-connected to the CAN line through the CAN communication module, and the microcontroller module is provided with eight buttons (potentiometer knobs) labeled A, B, C, D, E, F, G, and H, which can be expanded up to 16 knobs. Devices including the above CAN communication signal generator need to pre-write data into the device's memory, and by operating the knobs or buttons, output signals corresponding to the knobs or buttons are generated based on the stored data, thereby triggering the Electronic Control Unit (Electronic Control Unit, ECU) to send instructions.

However, devices including the above CAN communication signal generator are relatively inconvenient to use, and the method of modifying data is not flexible enough and is relatively cumbersome. When data needs to be modified, the device must be connected to a host computer, and the stored data in the device's memory is modified through the host computer, requiring additional hardware such as data cables, CAN (Controller Area Network, controller area network) boxes, computers, and host computers. Additionally, to connect or use data cables, CAN boxes, computers, and host computers, the device needs external or reserved interfaces, which affects the overall design and aesthetics of the device.

Based on the above considerations, to address the inconvenience of using devices for triggering battery apparatus output in scenarios such as testing or training related to battery apparatuses, the inventor, after in-depth research, designed a battery trigger device, including an input device and a message generation device; the message generation device includes a wireless communication module and a control module; the wireless communication module is wirelessly connected to the input device; the wireless communication module is configured to acquire target data sent by the input device; the message generation device is connected to the wireless communication module; the message generation device is configured to generate a target signal based on the target data and output the target signal to the management device of the target battery apparatus; and the target signal is used to trigger the target battery apparatus to output electrical energy.

With this structure of the battery trigger device, by sending different target data to the message generation device through the input device, data can be modified more conveniently, improving the ease of use of the battery trigger device. Additionally, while ensuring safety and without modifying or disassembling the wiring harness, the sent data of the message generation device can be wirelessly modified, stored, or deleted to achieve specific functions.

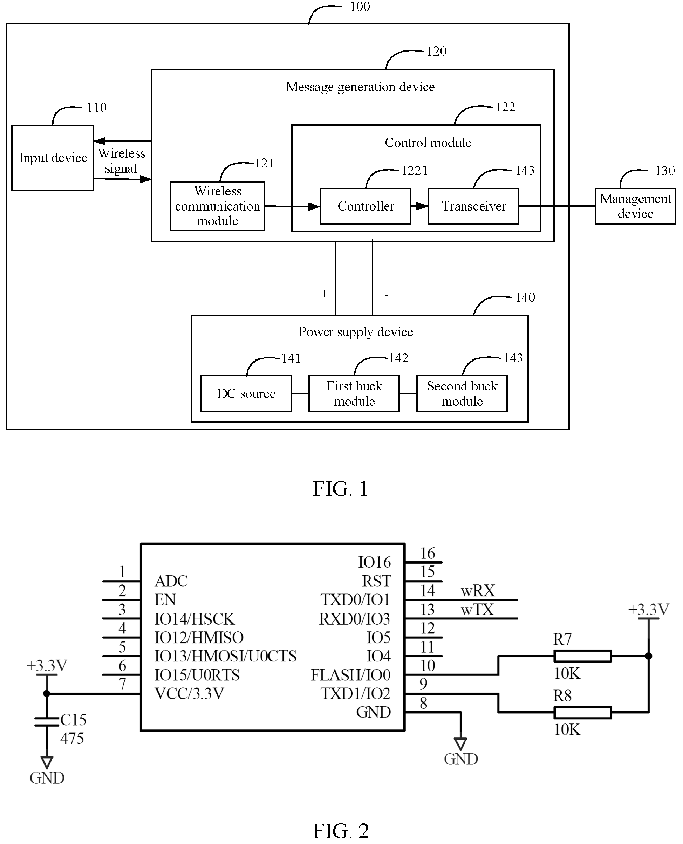

The battery trigger device, teaching aid, and test system according to the embodiments of this application are described below with reference to FIG. 1 to FIG. 9.

Referring to FIG. 1, a battery trigger device 100 includes: an input device 110 and a message generation device 120; wherein the message generation device 120 includes a wireless communication module 121 and a control module 122.

In actual implementation, the battery trigger device 100 provided in the embodiments of this application can be used for simulated triggering of a target battery apparatus. The target battery apparatus can be any type of battery apparatus. The battery apparatus can be a power battery or an energy storage battery, and the like. The battery apparatus may include one or more battery cell assemblies for providing voltage and capacity. The battery cell assembly may include multiple battery cells, with the multiple battery cells connected in series, parallel, or a combination thereof through busbar components.

The input device 110 and the message generation device 120 are separate structures, and the input device 110 and the message generation device 120 can be wirelessly connected for communication.

The input device 110 can be used for users to input target data. The message generation device 120 can generate a target signal for triggering the target battery apparatus to output electrical energy based on the target data input by the user. The target data may include message information corresponding one-to-one with the message generation device 120.

In some embodiments, the input device 110 may be provided with a display, as well as a keyboard and/or a mouse, and the like. The display can show a graphical user interface (Graphical User Interface, GUI). Based on the GUI, users can more conveniently input data through the keyboard and/or mouse. In some embodiments, the keyboard may include a virtual keyboard and/or a physical keyboard. In some embodiments, the mouse may include a virtual mouse and/or a physical mouse.

In some embodiments, data input through the input device 110 can be used to modify and save data for the message generation device 120 to generate the target signal, thereby addressing the issue of rewriting and saving data.

In some embodiments, the message generation device 120 may include a wireless communication module 121 and a control module 122. The wireless communication module 121 can wirelessly communicate with the input device 110, thereby receiving data input by the user through the input device 110. The control module 122 can generate a signal for triggering the target battery apparatus to output electrical energy based on the data input by the user.

The wireless communication module 121 is wirelessly connected to the input device 110; and the wireless communication module 121 is configured to acquire target data sent by the input device 110.

In actual implementation, the wireless communication module 121 and the input device 110 can be wirelessly connected for communication.

In some embodiments, the wireless communication module 121 may include at least one of a Wi-Fi module, a Bluetooth module, a Zigbee module, a 5G (5th Generation Mobile Communication Technology, 5th Generation Mobile Communication Technology) module, an NB-IoT (Narrow Band Internet of Things, narrow band internet of things) module, and a LoRa (Long Range Radio, long range radio) module.

For example, the wireless communication module 121 may include a Wi-Fi module. The Wi-Fi module can be used for complete and self-contained Wi-Fi network functions. The Wi-Fi module may internally integrate an antenna switch, RF balun (balun), power amplifier, low-noise amplifier, filter, and power management module, and the like. The Wi-Fi module can achieve fast switching between sleep mode and wake-up mode and adaptive radio frequency adjustments for low-power operation to achieve energy saving. The Wi-Fi module can have troubleshooting and radio frequency coexistence mechanisms to eliminate interference from cellular communication signals, Bluetooth signals, DDR (Double Data Rate Synchronous Dynamic Random Access Memory, double data rate synchronous dynamic random access memory), LVDS (Low-Voltage Differential Signaling, low-voltage differential signaling), and LCD (Liquid Crystal Display, liquid crystal display), and the like. The Wi-Fi module can support the TCP/IP protocol, fully comply with the 802.11b/g/n WLAN MAC protocol, support basic service set (Basic Service Set, BSS) STA operation and SoftAP operation under distributed coordination function (Distributed Coordination Function, DCF). The Wi-Fi module can support power consumption management by minimizing host interaction to optimize effective operating duration.

In some embodiments, the structure of the Wi-Fi module can be as shown in FIG. 2. FIG. 2 shows the main pins and peripheral circuits of the Wi-Fi module. Where, 3.3V indicates that the input voltage of the Wi-Fi module is 3.3V, but those skilled in the art can understand cases where the input voltage of the Wi-Fi module is other values. FIG. 2 also shows the numbering and parameters of components such as capacitors and resistors in the Wi-Fi module, for example, C15 and R7 are the component numbers, and 475 and 10K are the capacitance and resistance values, respectively.

In some embodiments, after the message generation device 120 is powered up, the wireless communication module 121 can generate a wireless signal (for example, a Wi-Fi module generates a Wi-Fi signal or a 5G module generates a 5G signal, and the like), and the input device 110 can connect to the message generation device 120 based on the wireless signal.

In some embodiments, the message generation device 120 may have a connection verification function to verify the devices connected thereto to ensure security.

The control module 122 is connected to the wireless communication module 121; the control module 122 is provided with a wired communication interface for connecting to a management device 130 of a target battery apparatus; the control module is configured to generate a target signal based on the target data and output the target signal to the management device; and the target signal is used to trigger the target battery apparatus to output electrical energy.

In actual implementation, the control module 122 can be connected to the wireless communication module 121 through a wired or wireless connection, so that the target data can be transmitted to the control module 122 through the wireless communication module 121.

In some embodiments, the control module 122 and the wireless communication module 121 can be disposed within the same housing.

The control module 122 may include a wired communication interface. Through this wired communication interface, the message generation device 120 can be connected to the management device of the target battery apparatus. The management device of the target battery apparatus can be a BMS or BMU.

The control module 122 can convert the target data into a target signal. The target signal can be a signal that conforms to the communication protocol used by the wired communication interface. In some embodiments, the target signal is an extended frame or standard frame signal. The extended frame or standard frame signal may have different baud rates and/or conform to different protocols. In some embodiments, the extended frame can be a common extended frame in the related art, and the standard frame can be a common standard frame in the related art.

It can be understood that the instruction data can be modified and saved through the input device 110, thereby achieving the modification and saving of target data, addressing the inconvenience of data rewriting and saving in the related art.

The specific type of the communication protocol is not limited in the embodiments of this application. For example, the communication protocol can be a CAN protocol, and accordingly, the target signal can be two analog CAN signals (which can be denoted as CANH and CANL or CAN-H and CAN-L); or the communication protocol can be a local interconnect network (Local Interconnect Network, LIN) protocol, and accordingly, the target signal can be a LIN signal.

It can be understood that after the battery management system receives the target signal transmitted by the message device, if the power-up conditions are met, it can control the target battery to power up with high voltage and output electrical energy, thereby meeting the high-voltage power-up requirements of the target battery.

It can be understood that after the target battery is powered up with high voltage, the functional integrity of high-voltage contactors and other components can be monitored.

According to the battery trigger device provided in the embodiments of this application, through the wireless connection between the input device and the wireless communication module of the message generation device, the target data input by the input device is transmitted to the control module of the message generation device via the wireless communication module. The control module generates a target signal based on the target data and outputs the target signal to the management device of the target battery apparatus to trigger the target battery apparatus to output electrical energy. This eliminates the need for expensive and cumbersome power distribution harnesses, resulting in a simpler and more aesthetically pleasing layout. There is no need for external or reserved interfaces, making the overall device appearance more attractive and facilitating easier and faster fault diagnosis. Without modifying or disassembling the wiring harness, a simple and compact message generation device, paired with a dedicated input device, can wirelessly modify, store, or delete the sent data of the message generation device to achieve specific functions. Data modification is simpler, more convenient, and flexible, enhancing the overall usability of the device. Additionally, by using the message generation device, connections to components such as the drive system, vehicle controller, and DC/DC converter can be reduced, lowering the failure rate during device power-up or use and reducing safety risks during high-voltage power-up of the battery apparatus.

In some embodiments, the control module 122 includes a controller 1221 and a transceiver 1222.

In actual implementation, the control module 122 can consist of the controller 1221 and the transceiver 1222, and the like.

The controller 1221 is connected to the wireless communication module 121; and the controller 1221 is configured to generate a target message based on the target data.

In actual implementation, the controller 1221 can be connected to the wireless communication module 121 through a wired or wireless connection to acquire the target data sent by the input device 110.

After acquiring the target data, the controller 1221 can process the target data and assemble the target message based on the target data.

In some embodiments, the controller 1221 can use a device with data processing capabilities, such as a CPU (Central Processing Unit, central processing unit) or FPGA (Field Programmable Gate Array, field programmable gate array).

In some embodiments, the controller 1221 can use any type of CPU.

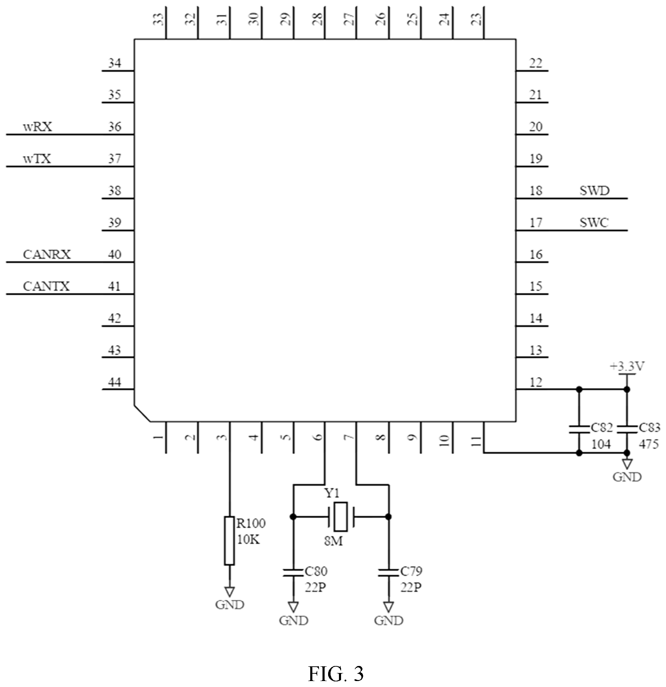

For example, the controller 1221 can use a CPU as shown in FIG. 3. FIG. 3 shows the main pins and peripheral circuits of the CPU, in which 3.3V indicates that the input voltage of the CPU module is 3.3V, but those skilled in the art can understand cases where the input voltage of the CPU module is other values. FIG. 3 also shows the numbering and parameters of components such as capacitors and resistors in the CPU, for example, C80 and R100 are the component numbers, and 22P and 10K are the capacitance and resistance values, respectively.

The CPU can use a 32-bit RISC (Reduced Instruction Set Computer, reduced instruction set computer) core, with a maximum operating frequency of up to 72MHz. The CPU can also include built-in high-speed memory and use a prefetch method to improve instruction access speed. Multiple buses in the system structure of the CPU can operate synchronously, and it can provide rich peripheral functions and enhanced I/O ports. The CPU can also have a built-in 12-bit ADC (Analog to Digital Converter, analog to digital converter) module (for example, an ADC module with a conversion time of less than 1µs), one 12-bit DAC (Digital to Analog Converter, digital to analog converter) module, four groups of 16-bit general-purpose timers, and multichannel touch key capacitance detection (TKey) devices or functions, and the like. The CPU can also include at least one standard communication interface, such as an I2C (Inter-Integrated Circuit) interface, SPI (Serial Peripheral Interface, serial peripheral interface), USART (Universal Synchronous/Asynchronous Receiver/Transmitter, universal synchronous/asynchronous receiver/transmitter) interface, CAN interface, and USB2.0 full-speed interface (for full/low-speed communication), and the like.

The core, DMA (Direct Memory Access, direct memory access) module, SRAM (Static Random-Access Memory, static random-access memory), and other parts in the CPU interact through multiple groups of buses. The CPU can also include a Flash access prefetch mechanism to accelerate code execution speed, and an integrated general-purpose DMA controller to reduce CPU load and improve efficiency. The CPU can also use a multi-level clock management mechanism to reduce peripheral functions, while incorporating data protection mechanisms and clock switching protection mechanisms to enhance system stability.

The transceiver 1222 can be connected to the CPU through a CAN interface for data transmission and control. The wireless communication module 121 can be connected to the CPU through a USART interface for data transmission and control.

The transceiver 1222 is connected to the controller 1221; the transceiver 1221 is configured to convert the target message into the target signal.

In actual implementation, the controller 1221 can also be connected to the transceiver 1222 through a wired or wireless connection to output the target message to the transceiver 1222.

The transceiver 1222 can convert the received target message into a target signal in an extended frame or standard frame according to the communication protocol it uses. The transceiver 1222 can also be connected to the management device of the target battery apparatus through a wired communication interface (for example, CAN interface or LIN interface, and the like), thereby outputting the target signal to the management device of the target battery apparatus.

In some embodiments, the transceiver 1222 can be a CAN transceiver. The CAN transceiver can generally be in the form of a CAN transceiver chip. Using a CAN transceiver can improve the stability and transmission distance of CAN signals.

In some embodiments, the CAN transceiver chip can be a high-speed CAN transceiver chip with isolation. This chip is an interface chip between the CAN protocol controller and the physical bus, capable of differential signal transmission between the bus and the CAN protocol controller. The chip can internally integrate all necessary CAN isolation and CAN transceiver components. The chip is fully compatible with the ISO 11898 standard and can interoperate with other CAN transceiver products that comply with the ISO 11898 standard. In some embodiments, the chip also complies with AEC-Q100 certification, includes built-in over-temperature protection and overcurrent protection, allows at least 110 nodes to connect to the bus, and supports a rate of up to 1Mbps.

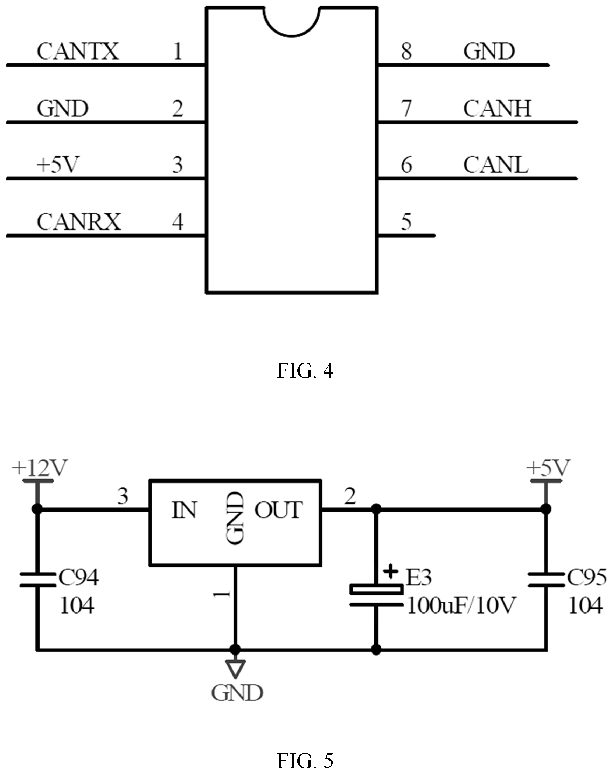

For example, the CAN transceiver chip can use a CPU as shown in FIG. 4. FIG. 4 shows the main pins and peripheral circuits of the CAN transceiver chip, in which +5V indicates that the input voltage of the CPU module is +5V, but those skilled in the art can understand cases where the input voltage of the CPU module is other values.

According to the battery trigger device provided in the embodiments of this application, the controller generates a target message based on the target data and sends the target message to the transceiver, where the transceiver converts the target message into a target signal and sends the target signal to the management device of the target battery apparatus, improving the stability and distance of target signal transmission.

In some embodiments, the battery trigger device further includes a power supply device 140; where the power supply device 140 is connected to the message generation device 120 to supply power to the message generation device 120.

In actual implementation, the battery trigger device can adopt an internal power supply method, by providing a power supply device 140 with the ability to store or output electrical energy to supply power to the message generation device 120. It can be understood that the power supply device 140 can be connected to the message generation device 120 through a power line to supply power to the message generation device 120, ensuring normal operation of the message generation device 120.

In some embodiments, upon receiving a specific instruction (for example, a demand for high-voltage power in a vehicle), the message generation device 120 can supply power to the message generation device 120 through the power line.

According to the battery trigger device provided in the embodiments of this application, the power supply device 140 supplies power to the message generation device 120, ensuring the normal operation of the message generation device, and the power supply is not restricted by external conditions, making the deployment and application of the battery trigger device more flexible.

In some embodiments, the power supply device 140 includes a DC source 141, a first buck module 142, and a second buck module 143.

In actual implementation, the DC source 141 can be a component of the power supply device 140 used to output electrical energy. The specific type of the DC source 141 is not limited in the embodiments of this application.

The power supply device 140 can adopt a multi-level buck mode to supply power to modules with different operating voltages included in the message generation device 120. In some embodiments, the power supply device 140 can adopt a two-level buck mode, that is, the power supply device 140 may include a first buck module 142 and a second buck module 143, where the first buck module 142 can reduce the first voltage output by the DC source 141 to a second voltage, and the second buck module 143 can further reduce the second voltage to a third voltage.

An input end of the first buck module 142 is connected to the DC source 141; an output end of the first buck module 142 is connected to both an input end of the second buck module 143 and a power supply end of the transceiver 1222; and an output voltage of the first buck module 142 is less than an input voltage of the first buck module 142.

In actual implementation, the input end of the first buck module 142 is connected to the DC source 141, so the input voltage of the first buck module 142 can be the output voltage of the DC source 141. The first buck module 142 can perform buck processing on the first voltage output by the DC source 141 to output a second voltage.

The output end of the first buck module 142 is connected to both the input end of the second buck module 143 and the power supply end of the transceiver 1222, supplying power to the transceiver 1222 on one hand and providing input voltage to the second buck module 143 on the other hand.

An output end of the second buck module 143 is connected to a power supply end of the controller 1221; and an output voltage of the second buck module 143 is less than an input voltage of the second buck module 143.

The specific circuit structures of the first buck module 142 and the second buck module 143 are not limited in the embodiments of this application.

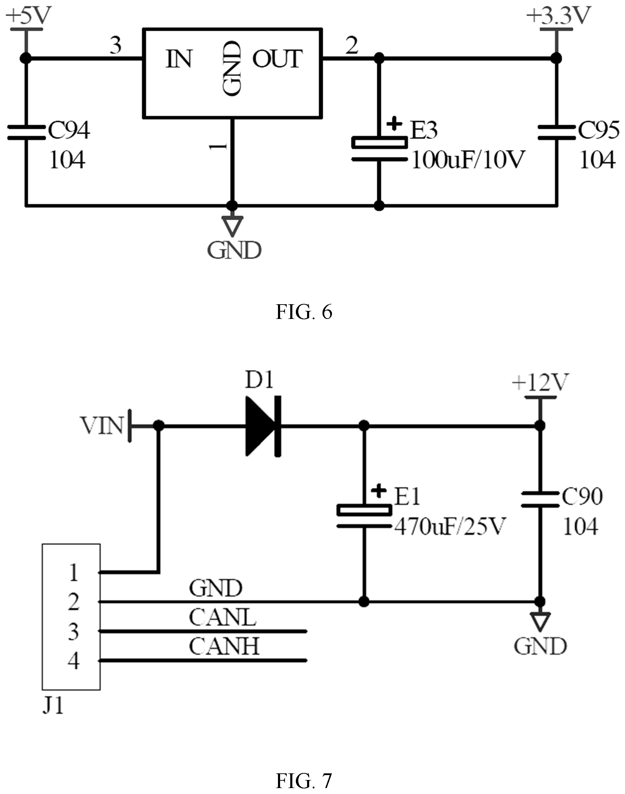

In some embodiments, the first buck module 142 and the second buck module 143 can adopt the circuit structures shown in FIG. 5 and FIG. 6, respectively. FIG. 5 and FIG. 6 also show the numbering and parameters of components such as capacitors and resistors in the first buck module 142 and the second buck module 143. The first buck module 142 can reduce 12V DC to 5V to supply power to the transceiver 1222 (for example, the CAN transceiver chip shown in FIG. 4), and the second buck module 143 can further reduce 5V to 3.3V to supply power to the controller 1221 (for example, the CPU shown in FIG. 3).

According to the battery trigger device provided in the embodiments of this application, the first buck module and the second buck module perform two-level buck conversion to supply power to the transceiver and the controller, respectively, ensuring normal operation of the transceiver and the controller.

In some embodiments, the output end of the second buck module 143 is connected to a power supply end of the wireless communication module 121.

In actual implementation, the second buck module 143 can also supply power to the wireless communication module 121. The output end of the second buck module 143 can also be connected to the power supply end of the wireless communication module 121 through a power line.

In some embodiments, the second buck module 143 shown in FIG. 6 can provide a 3.3V input voltage to the Wi-Fi module shown in FIG. 2.

According to the battery trigger device provided in the embodiments of this application, the second buck module supplies power to the wireless communication module, ensuring its normal operation.

In some embodiments, the message generation device 120 further includes a first buck unit and a second buck unit.

In actual implementation, the battery trigger device can adopt an external power supply method, that is, the battery trigger device does not include a power supply device, and electrical energy can be provided by an external DC source or AC source (for example, mains electricity, and the like).

The power supply to the message generation device 120 can also adopt a multi-level buck mode to supply power to modules with different operating voltages included in the message generation device 120. In some embodiments, the power supply to the message generation device 120 can adopt a two-level buck mode, that is, the message generation device 120 may include a first buck unit and a second buck unit, where the first buck unit can reduce a first voltage DC to a second voltage, and the second buck unit can further reduce the second voltage to a third voltage.

The output end of the first buck unit is connected to both the input end of the second buck unit and the power supply end of the transceiver; and the output voltage of the first buck unit is less than the input voltage of the first buck unit.

In actual implementation, the role and connection relationship of the first buck unit are similar to the role and connection relationship of the first buck module 142 described above, and will not be repeated here.

The output end of the second buck unit is connected to the power supply end of the controller; and the output voltage of the second buck unit is less than the input voltage of the second buck unit.

In actual implementation, the role and connection relationship of the second buck unit are similar to the role and connection relationship of the second buck module 143 described above, and will not be repeated here.

In some embodiments, the first buck unit and the second buck unit can also adopt the circuit structures shown in FIG. 5 and FIG. 6. The first buck unit can reduce 12V DC to 5V to supply power to the transceiver 1222 (for example, the CAN transceiver chip shown in FIG. 4), and the second buck unit can further reduce 5V to 3.3V to supply power to the controller 1221 (for example, the CPU shown in FIG. 3).

According to the battery trigger device provided in the embodiments of this application, the first buck module and the second buck module perform two-level buck conversion to supply power to the transceiver and the controller, respectively, ensuring normal operation of the transceiver and the controller.

In some embodiments, the message generation device 120 further includes a switching power supply; and an input end of the first buck unit is connected to the switching power supply.

In actual implementation, the message generation device 120 may include a switching power supply. An external AC source (for example, mains electricity, and the like) of the battery trigger device can be connected to the input end of the switching power supply, and the output end of the switching power supply can be connected to the input end of the first buck unit. The switching power supply can convert the input AC power into a first voltage DC output to the first buck unit.

According to the battery trigger device provided in the embodiments of this application, the switching power supply converts external AC power into DC power, making the power supply of the battery trigger device more stable.

In some embodiments, the output end of the second buck unit is connected to the power supply end of the wireless communication module.

In actual implementation, similar to the second buck module 143, the second buck unit can also supply power to the wireless communication module 121. The output end of the second buck unit can also be connected to the power supply end of the wireless communication module 121 through a power line.

In some embodiments, the second buck unit shown in FIG. 6 can provide a 3.3V input voltage to the Wi-Fi module shown in FIG. 2.

According to the battery trigger device provided in the embodiments of this application, the second buck unit supplies power to the wireless communication module, ensuring its normal operation.

In some embodiments, the input device 110 includes at least one of a terminal and a keyboard.

In actual implementation, the input device 110 can adopt a keyboard with wireless communication functions or a terminal with wireless communication functions.

The terminal includes, but is not limited to, portable communication devices such as mobile phones or tablets with touch-sensitive surfaces (for example, touchscreen displays and/or touchpads). It should also be understood that, in some embodiments, the terminal may not be a portable communication device but a desktop computer with a touch-sensitive surface (for example, a touchscreen display and/or touchpad).

In some embodiments, the terminal may include a display and a touch-sensitive surface. However, it should be understood that the terminal may include one or more other physical user interface devices, such as a physical keyboard, mouse, and joystick.

In actual implementation, target data can be input through software or an APP (application, application) running on the terminal.

According to the battery trigger device provided in the embodiments of this application, by using at least one of a terminal and a keyboard as the input device to input target data, it is more convenient to input and modify data used to generate the target signal, improving the flexibility, convenience, or efficiency of battery triggering.

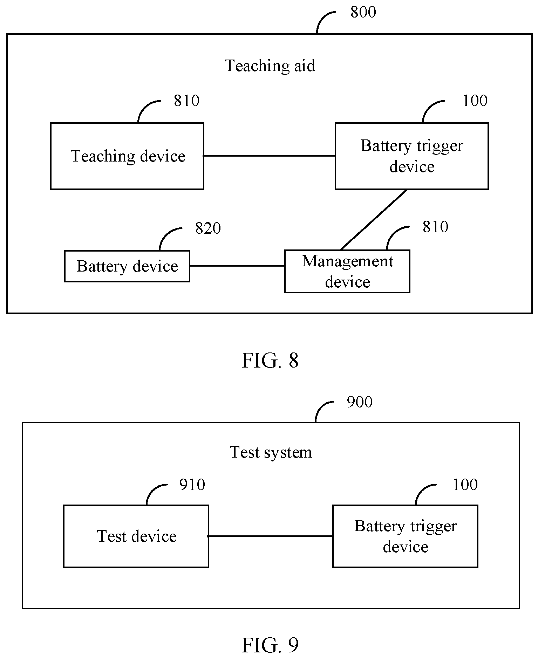

Embodiments of this application also provide a teaching aid. Referring to FIG. 8, the teaching aid 800 includes: a teaching device 810, a battery apparatus 820, a management device 130 of the battery apparatus 820, and a battery trigger device 100.

In actual implementation, the teaching aid 800 can be used as a teaching tool for battery apparatuses. The specific type of the teaching aid is not limited in the embodiments of this application. For example, the teaching aid 800 can be a battery system fault simulation test bench used to train students in identifying and handling battery apparatus faults by simulating battery system failures.

The teaching device 810 is connected to the battery trigger device 100; the battery trigger device 100 is connected to the management device 130; and the management device 130 is connected to the control end of the battery apparatus 820.

In actual implementation, the teaching device 810 is connected to the battery trigger device 100 to trigger the battery trigger device 100 to start operation, for example, it can control the power supply device 140 in the battery trigger device 100 to power up the message generation device 120.

The number of battery apparatuses 820 can be at least one. The control end of each battery apparatus 820 is connected to its own management device 130. One management device 130 can be connected to the control ends of one or more battery apparatuses 820.

The battery trigger device 100 can be the battery trigger device provided in any of the foregoing embodiments.

The battery trigger device 100 is connected to the management device 130 of each battery apparatus 820, so that the target signal generated by the battery trigger device 100 can be transmitted to the management device 130 of the target battery apparatus. Depending on different scenarios, the target battery apparatus can be one or more of the at least one battery apparatus 820 mentioned above.

The management device 130 of the target battery apparatus is connected to the control end of the target battery apparatus, thereby triggering the target battery based on the received target signal.

According to the teaching aid provided in the embodiments of this application, by adopting the battery trigger device provided in any of the foregoing embodiments, a simple and compact message generation device, paired with a dedicated input device, can wirelessly modify, store, or delete the sent data of the message generation device to achieve specific functions without modifying or disassembling the wiring harness, ensuring safety and improving ease of use.

In some embodiments, the teaching device 810 includes a housing; and the message generation device 120 of the battery trigger device 100 is disposed within the housing.

In actual implementation, the message generation device 120 can be disposed within the housing of the teaching device 810 to avoid frequent disassembly, movement, or damage. Users can operate the input device 110 outside the housing of the teaching device 810 to make the message generation device 120 emit a target signal, without needing to open the housing of the teaching device 810 to operate physical buttons of a communication signal generator as in the related art.

It should be noted that the message generation device 120 is very small in size, similar to a small MP3 player, and has little or no impact on the original design of the teaching aid 800 and the teaching device 810, thereby addressing the issue of the large size of communication signal generators in the related art.

According to the teaching aid provided in the embodiments of this application, by disposing the message generation device of the battery trigger device within the housing of the teaching device, the device is safer and more convenient for moving the teaching aid to various venues without affecting the generation of the target signal and the triggering of the target battery apparatus.

Embodiments of this application also provide a test system 900. Referring to FIG. 8, the test system 900 includes: a test device 910 and a battery trigger device 100; where the test device 910 is connected to the battery trigger device 100.

In actual implementation, the test system 900 can be used to test battery apparatuses. The battery apparatus to be tested can serve as the target battery apparatus. The number of battery apparatuses to be tested can be one or more.

Before starting the test, the control end of the battery apparatus to be tested can be connected to the management device of the battery apparatus, and the management device of the battery apparatus can be connected to the battery trigger device 100.

The battery trigger device 100 can be the battery trigger device provided in any of the foregoing embodiments.

The test device 910 can be connected to the battery trigger device 100 to trigger the battery trigger device 100 to start operation, for example, it can control the power supply device 140 in the battery trigger device 100 to power up the message generation device 120.

The target signal generated by the battery trigger device 100 can be transmitted to the management device 130 of the battery apparatus to be tested. The management device 130 of the battery apparatus to be tested can trigger the battery apparatus to be tested based on the received target signal, thereby enabling various tests on the battery apparatus to be tested.

According to the test system provided in the embodiments of this application, by adopting the battery trigger device provided in any of the foregoing embodiments, a simple and compact message generation device, paired with a dedicated input device, can wirelessly modify, store, or delete the sent data of the message generation device to achieve specific functions without modifying or disassembling the wiring harness, ensuring safety and improving ease of use.

In some embodiments, the test device 910 includes a housing; and the message generation device 120 of the battery trigger device 100 is disposed within the housing.

In actual implementation, the message generation device 120 can be disposed within the housing of the test device 910 to avoid frequent disassembly, movement, or damage. Users can operate the input device 110 outside the housing of the test device 910 to make the message generation device 120 emit a target signal, without needing to open the housing of the teaching device 810 to operate physical buttons of a communication signal generator as in the related art.

It should be noted that the message generation device 120 is very small in size, similar to a small MP3 player, and has little or no impact on the original design of the test system 900 and the test device 910, thereby addressing the issue of the large size of communication signal generators in the related art.

According to the test system provided in the embodiments of this application, by disposing the message generation device of the battery trigger device within the housing of the test device, the device is safer and more convenient for moving the teaching device to various venues without affecting the generation of the target signal and the triggering of the target battery apparatus.

The above are only preferred embodiments of this application and are not intended to limit this application. For those skilled in the art, various modifications and changes can be made to this application. Any modifications, equivalent substitutions, improvements, and the like, made within the spirit and principles of this application should be included in the protection scope of this application.

## Claims

1. A battery trigger device, **characterized by** comprising: an input device and a message generation device; wherein the message generation device comprises a wireless communication module and a control module;
the wireless communication module is wirelessly connected to the input device; and the wireless communication module is configured to acquire target data sent by the input device; and
the control module is connected to the wireless communication module; the control module is provided with a wired communication interface for connecting to a management device of a target battery apparatus; the control module is configured to generate a target signal based on the target data and output the target signal to the management device; and the target signal is used to trigger the target battery apparatus to output electrical energy.

2. The battery trigger device according to claim 1, **characterized in that** the control module comprises a controller and a transceiver;
the controller is connected to the wireless communication module; and the controller is configured to generate a target message based on the target data; and
the transceiver is connected to the controller; and the transceiver is configured to convert the target message into the target signal.

3. The battery trigger device according to claim 2, **characterized in that** the transceiver is a CAN transceiver.

4. The battery trigger device according to claim 2 or 3, **characterized by** further comprising a power supply device; wherein the power supply device is connected to the message generation device to supply power to the message generation device.

5. The battery trigger device according to claim 4, **characterized in that** the power supply device comprises a DC source, a first buck module, and a second buck module;
an input end of the first buck module is connected to the DC source; an output end of the first buck module is connected to both an input end of the second buck module and a power supply end of the transceiver; and an output voltage of the first buck module is less than an input voltage of the first buck module; and
an output end of the second buck module is connected to a power supply end of the controller; and an output voltage of the second buck module is less than an input voltage of the second buck module.

6. The battery trigger device according to claim 5, **characterized in that** the output end of the second buck module is connected to a power supply end of the wireless communication module.

7. The battery trigger device according to any one of claims 2 to 6, **characterized in that** the message generation device further comprises a first buck unit and a second buck unit;
an output end of the first buck unit is connected to both an input end of the second buck unit and the power supply end of the transceiver; and an output voltage of the first buck unit is less than an input voltage of the first buck unit; and
an output end of the second buck unit is connected to the power supply end of the controller; and an output voltage of the second buck unit is less than an input voltage of the second buck unit.

8. The battery trigger device according to claim 7, **characterized in that** the message generation device further comprises a switching power supply; and an input end of the first buck unit is connected to the switching power supply.

9. The battery trigger device according to claim 7 or 8, **characterized in that** the output end of the second buck unit is connected to the power supply end of the wireless communication module.

10. The battery trigger device according to claim 1, **characterized in that** the input device comprises at least one of a terminal and a keyboard.

11. A teaching aid, **characterized by** comprising: a teaching device, a battery apparatus, a management device of a target battery apparatus, and the battery trigger device according to any one of claims 1 to 10; wherein
the teaching device is connected to the battery trigger device; the battery trigger device is connected to the management device; and the management device is connected to a control end of the battery apparatus.

12. The teaching aid according to claim 11, **characterized in that** the teaching device comprises a housing; and the message generation device of the battery trigger device is disposed within the housing.

13. A test system **characterized by** comprising: a test device and the battery trigger device according to any one of claims 1 to 10; wherein the test device is connected to the battery trigger device.

14. The test system according to claim 13, **characterized in that** the test device comprises a housing; and the message generation device of the battery trigger device is disposed within the housing.
